Europäisches Patentamt

European Patent Office

Office européen des brevets

(19)

(11) Veröffentlichungsnummer: **0 099 418**

A1

(12) **EUROPÄISCHE PATENTANMELDUNG**

(21) Anmeldenummer: **82106561.2**

(22) Anmeldetag: **21.07.82**

(51) Int. Cl.³: **H 04 B 9/00**
**H 01 S 3/13**

(43) Veröffentlichungstag der Anmeldung:
**01.02.84** Patentblatt **84/5**

(84) Benannte Vertragsstaaten:
**CH DE FR GB LI NL**

(71) Anmelder: **ANT Nachrichtentechnik GmbH**
**Gerberstrasse 33**
**D-7150 Backnang(DE)**

(72) Erfinder: **Schmack, Hans-Jürgen, Ing. grad.**
**Wunnensteinstrasse 3**
**D-7151 Allmersbach im Tal(DE)**

(74) Vertreter: **Schickle, Gerhard, Dipl.-Ing. et al,**
**ANT Nachrichtentechnik GmbH Patent- und**
**Lizenzabteilung Gerberstrasse 33**
**D-7150 Backnang(DE)**

(54) Verfahren zum Regeln des Ausgangssignals eines optischen Senders, der an einem Hin- und Rücksignale führenden Lichtwellenleiter angekoppelt ist.

(57) Die vorliegende Erfindung gibt ein mit geringem Schaltungsaufwand realisierbares Verfahren an zum Regeln des Ausgangssignals (S2) eines optischen Senders (3), der zusammen mit einem optischen Empfänger (4) an einen Lichtwellenleiter (1) angekoppelt ist, über den optische Signale (S2,S1) sowohl in Hin- als auch in Rückrichtung übertragen werden. Dazu wird aus dem Lichtwellenleiter (1) neben dem Empfangssignal (S1') ausgekoppelt und dem optischen Empfänger (4) zugeführt und das vom Sendesignalanteil herrührende Ausgangssignal (S2') des Empfängers (4) als Regelgröße für den optischen Sender (3) herangezogen.

EP 0 099 418 A1

- 2 -

AEG-TELEFUNKEN                              K1 E7/Th/ma
Nachrichtentechnik GmbH                     BK 81/123
Gerberstraße 33
7150 Backnang

Verfahren zum Regeln des Ausgangssignals eines optischen Senders, der an einem Hin- und Rücksignale führenden Lichtwellenleiter angekoppelt ist

Die vorliegende Erfindung betrifft ein Verfahren zum Regeln des Ausgangssignals eines optischen Senders, der zusammen mit einem optischen Empfänger an einen Lichtwellenleiter angekoppelt ist, über den optische Signale sowohl in Hin- als auch in Rückrichtung übertragen werden.

Aus der DE-OS 30 45 876 ist ein optisches Übertragungssystem bekannt, bei dem über einen Lichtwellenleiter in Hin- und Rückrichtung Signale übertragen werden. Z.B. werden in die eine Richtung Rundfunk- oder Fernsehkanäle von einer Zentrale aus übertragen, die am teilnehmerseitigen Ende des Lichtwellenleiters empfangen werden, und in die Gegenrichtung werden vom Teilnehmer Programmwahlsignale an die Zentrale ausgesandt.

Der Erfindung liegt die Aufgabe zugrunde, speziell für ein solches Übertragungssystem ein Verfahren zum Regeln des Ausgangssignals eines zusammen mit einem Empfänger an einem Ende eines Lichtwellenleiters angekoppelten Senders anzugeben, das mit einem möglichst geringen Aufwand an Schaltungselementen realisierbar ist.

Erfindungsgemäß wird die Aufgabe dadurch gelöst, daß aus dem Lichtwellenleiter neben dem Empfangssignal auch ein Anteil des Sendesignals ausgekoppelt und dem optischen Empfänger zugeführt wird, und daß das vom Sendesignalanteil herrührende Ausgangssignal des Empfängers herangezogen wird als Regelgröße für den optischen Sender.

Eine zweckmäßige Anordnung zur Durchführung des Verfahrens geht aus dem Unteranspruch hervor.

Durch die Ausnutzung des Empfängers in doppelter Funktion, nämlich zum Empfang des Siganls der Rückrichtung und eines Teils des Signals der Hinrichtung, spart man ein zusätzliches Bauelement ein, was nur für die Ableitung einer Regelgröße aus dem Ausgangssignal des Senders zuständig ist.

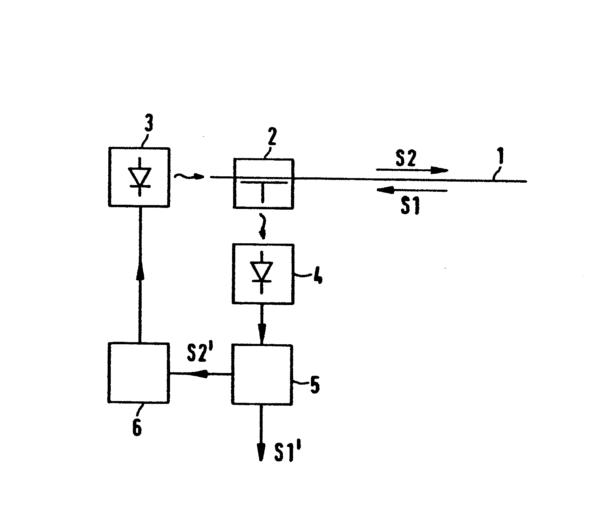

Anhand eines in der Zeichnung dargestellten Ausführungsbeispiels soll nun die Erfindung näher erläutert werden.

Die Figur zeigt den teilnehmerseitigen Endabschnitt eines Lichtwellenleiters 1, über den in Hinrichtung ein von einer Zentrale ausgesandtes Signal S1 (z.B. Rundfunk- oder Fernsehsignal) und in Rückrichtung ein vom Teilnehmer ausgesandtes Signal S2 (z.B. zur Auswahl eines der von der Zentrale angebotenen Programme) übertragen wird.

Am Ende des Lichtwellenleiters sind mittels eines Kopplers 2 ein optischer Sender 3 (z.B. eine Laserdiode) und ein optischer Empfänger 4 (z.B. eine Photodiode) angekoppelt. Über den Koppler wird dem Empfänger das von der Zentrale ausgesandte Signal S1, aber auch ein Teil des Signals S2, das vom Sender 3 in den Lichtwellenleiter 1 eingespeist wird, zugeführt.

In einem Schaltblock 5 werden die elektrischen, von den optischen Signalen S1 und S2 abgeleiteten Ausgangssignale S2' und S1' des optischen Empfängers 4 getrennt. Sollte man zur Unterscheidung die Signale S1 und S2 verschiedenen Frequenzen zuordnen, so wäre für den Schaltblock 5 eine Frequenzweiche einzusetzen.

Aus dem dem Senderausgangssignal S2 proportionalen Signal S2' wird schließlich in einem Schaltblock eine Regelgröße für den Vorstrom und/oder den Modulationsstrom des Senders abgeleitet. Darauf, welche Schaltungsmimik hierfür der Schaltblock 6 enthalten müßte, sei hier nicht näher eingegangen. Es bieten sich Schaltungen zur Ableitung der Regelgröße an, wie sie z.B. aus den Veröffentlichungen DE-OS 30 45 511 und DE-OS 30 45 545 hervorgehen.

. . . . . . . . . .

AEG-TELEFUNKEN
Nachrichtentechnik GmbH
Gerberstraße 33
7150 Backnang

K 1 E7/Th/ma
BK 81/123

Patentansprüche

1. Verfahren zum Regeln des Ausgangssignals eines optischen
Senders, der zusammen mit einem optischen Empfänger an einen Lichtwellenleiter angekoppelt ist, über den optische
Signale sowohl in Hin- als auch in Rückrichtung übertragen
werden, <u>dadurch gekennzeichnet,</u> daß aus dem Lichtwellenleiter (1) neben dem Empfangssignal (S1) auch ein Anteil des
Sendesignals (S2) ausgekoppelt und dem optischen Empfänger
(4) zugeführt wird und daß das vom Sendesignalanteil herrührende Ausgangssignal (S2') des Empfängers herangezogen
wird als Regelgröße für den optischen Sender (S3).

2. Anordnung zur Durchführung des Verfahrens nach Anspruch 1,
<u>dadurch gekennzeichnet,</u> daß in den Lichtwellenleiter (1)
ein optischer Koppler (2) eingefügt ist, der von beiden
entgegengesetzten Seiten eingespeistes Licht an den mit
dem optischen Empfänger (4) beschalteten Ausgang durchläßt.

Europäisches
Patentamt

## EUROPÄISCHER RECHERCHENBERICHT

| EINSCHLÄGIGE DOKUMENTE | | | EP 82106561.2 |
|---|---|---|---|

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| X | PATENT ABSTRACTS OF JAPAN, unexamined applications, Section E, Band 3, Nr. 60, 23. Mai 1979 THE PATENT OFFICE JAPANESE GOVERNMENT, Seite 124 E 113 <br><br> * Kokai-Nr. 54-41 001 (FUJITSU) * <br><br> -- | 1,2 | H 04 B 9/00 <br> H 01 S 3/13 |
| X | JP - A - 54-41 001 (FUJITSU) <br> * Fig. 1,2 * <br><br> -- | 1,2 | |
| X | EP - A1 - 0 028 669 (FELTEN & GUILLEAUME) <br><br> * Fig. 1: Seite 4, Zeile 13 - Seite 5, Zeile 8 * <br><br> -- | 1,2 | |
| A | DE - B2 - 2 652 608 (LICENTIA) <br> * Fig. 2 * <br><br> -- | 1,2 | **RECHERCHIERTE SACHGEBIETE (Int. Cl. ³)** <br><br> H 04 B 9/00 <br> H 01 S 3/00 |
| A | GERHARD GRAU "Optische Nachrichtentechnik", 1981 SPRINGER-VERLAG, Berlin, Heidelberg, New York Seiten 296-302 <br><br> * Seite 302, Bild 7.19 * <br><br> -- | 1,2 | |

Der vorliegende Recherchenbericht wurde für alle Patentansprüche erstellt.

| Recherchenort | Abschlußdatum der Recherche | Prüfer |
|---|---|---|
| WIEN | 04-02-1983 | DRÖSCHER |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503. 03.82

Europäisches
Patentamt

**EUROPÄISCHER RECHERCHENBERICHT**

| | **EINSCHLÄGIGE DOKUMENTE** | | **KLASSIFIKATION DER ANMELDUNG (Int. Cl.³)** |
|---|---|---|---|
| Kategorie | Kennzeichnung des Dokuments mit Angabe, soweit erforderlich, der Maßgeblichen Teile | betrifft Anspruch | |
| A | M.J. HOWES U. D.V. MORGAN, "Optical Fibre Communications", 1980 <br><br> JOHN WILEY & SONS, Chichester–New York–Brisbane–Toronto, Seiten 239–241 <br><br> * Seite 240, Zeilen 1–25 * <br><br> -- | | |
| D,A | DE - A1 - 3 045 876 (LICENTIA) <br> * Fig. 1 * <br><br> -- | 1,2 | **RECHERCHIERTE SACHGEBIETE (Int. Cl.³)** |
| D,A | DE - A1 - 3 045 511 (LICENTIA) <br><br> -- | | |
| D,A | DE - A1 - 3 045 545 (LICENTIA) <br><br> ---- | | |